# EUROPEAN PATENT SPECIFICATION

(11) **EP 0 678 873 B1**
(45) Date of publication and mention of the grant of the patent: **07.06.2000**
(21) Application number: 94830071.0
(22) Date of filing: 18.02.1994
(51) Int. Cl.: G11C 16/06, G11C 7/00

(54) **Load signal generating method and circuit for non-volatile memories**
Verfahren und Schaltung zur Erzeugung eines Ladesignals für nichtflüchtige Speichern
Procédé et circuit de génération de signal de charge pour mémoire non-volatile

(43) Date of publication of application: 25.10.1995
(73) Proprietor: STMicroelectronics S.r.l., 20041 Agrate Brianza (Milano) (IT)
(72) Inventor: Pascucci, Luigi, I-20099 Sesto San Giovanni (IT); Golla, Carla Maria, I-20099 Sesto San Giovanni (IT)
(74) Representative: Cerbaro, Elena, Dr.

(56) References cited:
- EP-A- 0 470 719
- US-A- 4 800 552
- IBM TECHNICAL DISCLOSURE BULLETIN vol. 32, no. 6B , November 1989 , NEW YORK US pages 415 - 416 XP000073746 'Reduced power for high performance memory'

## Description

The present invention relates to a load signal generating method and circuit for nonvolatile memories.

As is known, when dealing with timed memories, single timing is seldom enough in that, for it to function reliably, the memory must be free of as yet uncertain lines (at intermediate level) which may possibly impair the outcome of a reading which, in the event of a read error, cannot be repeated.

Such uncertain conditions normally occur when the memory is started, due to the slowness with which the various parts are turned on, though such uncertain conditions are not limited to the memory turning on. A strong demand now exists for memories with increasingly complex performance features, including the possibility of operating the memory in low-power mode wherein lines vital for operation of the memory are switched to reduce consumption due to power loss. These lines are normally slow in being restored to the correct level following low-power operating mode, and are particularly so in the event the memory has a voltage boost circuit which is invariably slow in responding to enabling of the memory.

As a result, when dealing with memories which are restarted repeatedly during operation, the problem of safely preventing reading errors is particularly felt.

US-A-4,800,552 discloses a memory device of the SRAM type, having a reset circuit for equalizing the potentials of two signal lines (bit lines or data bus lines) wherein, for allowing reliable equalization following a short chip selection circuit, two clock signals with equal duration are generated at different times and then summed to obtain a longer reset or equalizing signal.

It is an object of the present invention to provide a method and circuit for preventing reading errors even in the event of slow response of the memory, e.g. when it is restarted.

According to the present invention, there are provided a load signal generating method and circuit for nonvolatile memories, as claimed respectively in Claims 1 and 2.

In practice, according to the present invention, the data load pulse is modulated as best suited to the momentary requirements of the memory selecting a short load pulse or a long load pulse. In particular, the duration of the load pulse is extended whenever the memory requires it, and whenever the memory is started or restarted following low-power operating mode. Provision is also made for static operation with a continuous load pulse.

A preferred, non-limiting embodiment of the present invention will be described by way of example with reference to the accompanying drawings, in which:
Figure 1 shows a timing circuit for generating a data load signal in accordance with the present invention;
Figure 2 shows a plot of a number of signals in the Figure 1 circuit.

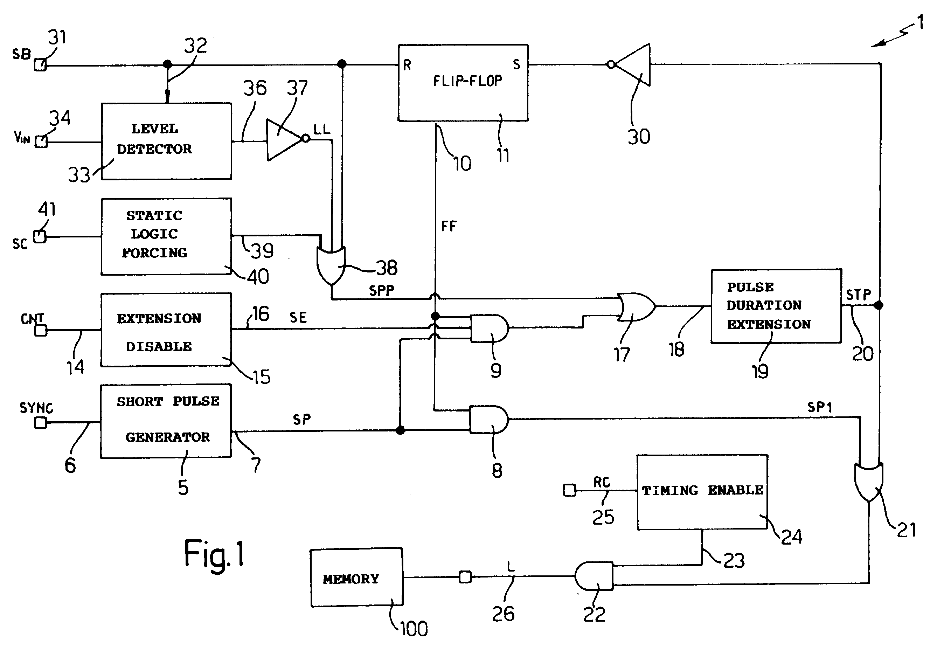

In Figure 1, the timing circuit is indicated as a whole by 1, and generates a data load signal L for a memory 100.

Circuit 1 comprises a short pulse source or generator 5 having an input 6 supplied with a synchronizing signal SYNC, and an output 7 supplying a load pulse signal SP. Output 7 is connected to one input of a first two-input AND gate 8, and to one input of a second three-input AND gate 9. The second input of AND gate 8 and a second input of AND gate 9 are connected to the output 10 of a bistable multivibrator or flip-flop 11 having a set input S and a reset input R, and which provides for memorizing the entering and exiting of critical conditions.

The third input of AND gate 9 is connected to the output 16 of an extension enabling and disabling block 15 having an input 14 (supplied with signal CNT) and generating an extension disabling output signal SE as explained later on. The output of AND gate 9 is connected to one input of an OR gate 17, the output of which is connected to the input 18 of a pulse duration extending block 19. Block 19 is composed substantially of a one-switching edge-delay single-shot circuit generating at output 20 an extended pulse signal STP which is high as long as input 18 is high, and which switches to low with a predetermined delay when the signal at input 18 switches to low.

Output 20 of block 19 and the output of AND gate 8 (supplying pulse signal SP1) are connected to the inputs of an OR gate 21, the output of which is connected to one input of an AND gate 22 having a second input connected to the output 23 of a timing enabling block 24 in turn presenting an input 25 supplied with signal RC. The output 26 of AND gate 22 represents the output of timing circuit 1, at which load signal L is supplied.

Output 20 of block 19 is also connected to input S of flip-flop 11 via an inverter 30. Input R of flip-flop 11 is connected to the input node 31 of circuit 1, which is supplied with a standby signal SB and is also connected to the input 32 of a level detector 33. Level detector 33 is connected to an input node 34 (supplied with controlled voltage V_{IN}) and presents an output 36 connected to the input of an inverter 37, the output of which (supplying a low-voltage signal LL) is connected to a first input of a three-input OR gate 38. A second input of OR gate 38 is connected to input node 31, and the third input is connected to the output 39 of a static logic forcing block 40 connected to an input node 41 supplying signal SC. The output of OR gate 38 (supplying static operating control signal SPP) is connected to one input of OR gate 17.

In circuit 1, signals SB, SC, CNT, SYNC, RC and voltage V_{IN} are supplied by memory 100. Level detector 33 compares controlled voltage V_{IN} with a predetermined threshold, and generates at output 36 a logic signal which is high when controlled voltage V_{IN} is above the threshold (so that signal LL is low) and vice versa.

On the basis of the logic level of signal SC, static logic forcing block 40 generates a high output signal for forcing static operation of circuit 1 (e.g. during testing).

Extension disabling block 15 provides for preventing extension of the load pulse under particular operating conditions of memory 100, on the basis of the logic level of signal CNT or the settings of memory elements (e.g. fuses) in or external to block 15, and generates a low logic signal for disabling extension of the load pulses.

Timing enabling block 24 provides for blocking the timing signals when they are not required by memory 100 (in which case, the signal at output 23 and load signal L are low).

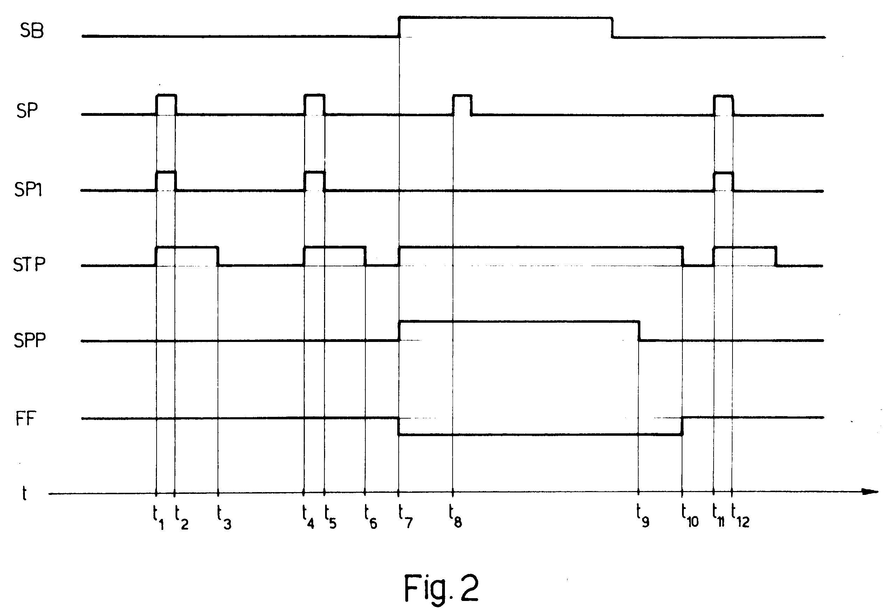

Operation of circuit 1 will now be described with reference also to Figure 2 which shows the logic levels of the main signals in various operating conditions.

In steady-state operating mode, and if static operation is not enabled, standby signal SB is low; the output of the level detector is high (so that the output of inverter 37 is low); the signal at output 39 of block 40 is low; signal SE is high; and output signal FF of flip-flop 11 is high. In this condition, on receiving the SYNC signal, short pulse source 5 generates a pulse of predetermined (short) duration, with a leading edge at instant t₁ and a trailing edge at instant t₂ (signal SP).

Similarly, signal SP1 presents a pulse of the same duration. The pulse of signal SP is also supplied to the input of duration extending block 19, the output signal STP of which immediately switches to high where it remains as long as signal SP is high. Signal STP also remains high when signal SP switches to low for a given period of time, after which block 19 also switches (instant t₃). The signal at the output of OR gate 21 thus presents an extended pulse equal to that of signal STP.

The above performance is repeated as long as signal SPP remains low (instants t₄-t₆). Supposing, now, memory 100 switches to standby at instant t₇. In this case, signal SB switches to high, thus resetting flip-flop 11 (output signal FF switches to low and SPP to high) and enabling static operating mode.

As a result, signal STP switches to and remains high; AND gates 8 and 9 prevent the passage of any signal pulses SP (as shown, for example, at instant t₈); the output of level detector 33 also switches to low due to the fall in controlled voltage V_{IN}; and signal LL switches to high, so that signal L at output 26 presents a continuous high level.

The above condition persists as long as signal SB remains high. Upon SB switching to low, however, the circuit does not switch, due to LL remaining high. As soon as the external device becomes operative (i.e. voltage V_{IN} again exceeds the predetermined threshold value), the output of detector 33 switches to high and LL (and the outputs of circuits 38, 17) to low; signal SPP switches to low, generating a trailing edge in the signal at input 18 (instant t₉); after the predetermined delay, signal STP at the output of extending block 19 also switches (instant t₁₀) and, inverted by inverter 30, again sets flip-flop 11; signal L at output 26 also switches to low; gates 8, 9 are again enabled, thus terminating static operation; and the next pulse of signal SP (instant t₁₁) is supplied to block 19 by which it is extended as described above.

The same static operation is enabled when requested, via signal SC at input 41, by memory 100 or other elements for special functions (such as testing or displaying data from registers or other parts of the memory) and in the event, for any reason, of a fall in voltage which may impair reading accuracy (critical memory operating condition). Conversely, when not required, pulse extension may be disabled in steady-state (i.e. noncritical) mode, in which case, the level of signal CNT at input 14 is such as to switch signal SE to low and so prevent signal SP from being transmitted to block 19.

The advantages of the circuit described are as follows. Firstly, it provides for adapting pulse duration to the conditions of the memory, by generating a short read pulse when conditions are such as to ensure correct reading in a short space of time, thus speeding up operation and reducing the risk of the data being damaged, and by generating extended load pulses when the memory requires a longer read time, e.g. for stabilizing important line voltage levels, and when premature reading may result in read errors. As such, the circuit elements involved in the reading (e.g. the sense amplifiers) are allowed sufficient time to reach the correct voltage level corresponding to the read data.

The circuit described always provides for extended timing when exiting standby mode; and reading is always terminated with a certain delay upon the controlled voltage reaching the required nominal level, thus ensuring correct reading. In standby mode, the transmission paths of any short pulses are interrupted, to prevent error; and, even in the event extended timing is not generally required (low EN signal), the pulse is nevertheless extended when exiting critical conditions (standby, low-voltage, static-logic mode).

When required, the circuit according to the present invention provides for generating a static condition signal.

As such, notwithstanding the extremely simple structure of the circuit according to the present invention, it provides for a highly flexible load pulse and a high degree of reliability.

Clearly, changes may be made to the circuit as described and illustrated herein without, however, departing from the scope of the present invention. In particular, the duration of the extended pulse may be predetermined or adjusted to the characteristics and requirements of the memory by providing and supplying a special input in block 19 with an analog or digital signal, the value of which determines the extent by which switching of the output of block 19 is delayed with respect to a given switching edge of the signal at input 18.

## Claims

1. A load signal generating method for nonvolatile memories, comprising the step of generating a load signal (L) presenting a load enabling pulse; characterized in that said step of generating said load signal comprises the step of modulating the duration of said load enabling pulse including the steps of generating a short load pulse (SP); generating a long load pulse (STP) from said short load pulse; and selectively picking up said short load pulse or said long load pulse.

2. A load signal generating circuit (1) for nonvolatile memories, comprising a generator (1) of a load signal (L) having a load enabling pulse; characterized in that said generator (1) comprises modulating means (5, 19, 21) for modulating the duration of said load enabling pulse, said modulating means comprising source means (5) for generating at the output a short load signal (SP) with a pulse of a first duration; duration extending means (19) supplied at the input with said short load signal (SP) and generating at the output an extended signal (STP) with a pulse of a second duration greater than said first duration; and selecting means (21) connected to said outputs of said source means and said duration extending means, for selectively supplying at the output (26) said short load signal or said extended signal.

3. A circuit as claimed in Claim 2, characterized in that it comprises extension enabling/disabling means (15) connected to said duration extending means (19), for generating an enabling signal (SE).

4. A circuit as claimed in Claim 2 or 3, characterized in that said duration extending means (19) comprise a delay block (19) with a control input (18), for generating a first switching edge of said extended signal (STP) upon detection of a predetermined switching edge at said control input, and for generating a second switching edge of said extended signal with a delay with respect to a second switching edge at said control input (18).

5. A circuit as claimed in Claim 4, characterized in that it comprises extension control means (9, 38) connected to said control input (18) of said delay block (19).

6. A circuit as claimed in Claim 5, characterized in that said extension control means (9, 38) comprise controlled switch means (9) interposed between said output (7) of said source means (5) and said control input (18), and having at least one control terminal connected to extension disabling means (15).

7. A circuit as claimed in Claim 6, characterized in that said controlled switch means (9) has a second control terminal connected to reconfigurable memory means (11) having a first input (R) supplied with a reduced operating mode signal (SB), and an output (10) supplying a disabling signal (FF); said memory means (11) generating a first level of said disabling signal on receiving said reduced operating mode signal (SB).

8. A circuit as claimed in Claim 7, characterized in that said reconfigurable memory means (11) has a second input (S) connected to the output (20) of said delay block (19); said memory means (11) generating a second level of said disabling signal (FF) upon detection of said second switching edge of said extended signal (STP).

9. A circuit as claimed in one of Claims 5-8, characterized in that said extension control means (9, 38) comprise static operation enabling means (38) for supplying a signal (SPP) of a predetermined logic level at said control input (18).

10. A circuit as claimed in Claim 9, characterized in that said static operation enabling means (38) are connected at the input to means (37) for generating a low-level signal (LL), to means (31) for generating said reduced operation mode signal (SB), and to means (40) for generating a static operation request signal.

## Patentansprüche

1. Verfahren zur Erzeugung eines Ladesignals für nichtflüchtige Speicher, bei dem ein Ladesignal (L) einen Ladesignal-Impuls aufweist,
dadurch gekennzeichnet, daß der Schritt des Erzeugens des Ladesignals den Schritt aufweist, die Zeitdauer des Lade-Aktivier-Impulses zu modulieren, wobei dieser Schritt die folgenden Unterschritte enthält:
Erzeugen eines kurzen Ladeimpulses (SP);
Erzeugen eines langen Ladeimpulses (STP) aus dem kurzen Ladeimpuls; und
selektives Abgeben des kurzen Ladeimpulses oder des langen Ladeimpulses.

2. Schaltung (1) zur Erzeugung eines Ladesignals für nichtflüchtige Speicher mit einem Generator (1) für ein Ladesignal (L), das einen Lade-Aktivier-Impuls aufweist;
dadurch gekennzeichnet, daß
der Generator (1) eine Modulationseinrichtung (5, 19, 21) zur Modulation der Zeitdauer des Lade-Aktivier-Impulses aufweist,
wobei die Modulationseinrichtung (5, 19, 21) eine Signalquelleneinrichtung (5), die an ihrem Ausgang ein kurzes Ladesignal (SP) mit einem Impuls, der eine kurze Zeitdauer besitzt, erzeugt,
eine Zeitdauer-Ausdehnungseinrichtung (19), die an dem Eingang mit dem kurzen Ladesignal (SP) versorgt wird, und an dem Ausgang ein ausgedehntes Signal STP mit einem Impuls erzeugt, welcher eine Zeitdauer aufweist, die größer ist als die erste Zeitdauer; und eine Auswahleinrichtung (21) aufweist, die an die Ausgänge der Signalquellen-Einrichtung (5) und der Zeitdauer-Ausdehnungseinrichtung (19) angeschlossen ist zur selektiven Abgabe des kurzen Ladesignals oder des ausgedehnten Signals an einem Signalausgang (26).

3. Schaltung nach Anspruch 2,
dadurch gekennzeichnet, daß sie eine Aktivier-/Deaktivier-Einrichtung (15) aufweist, die an die Zeitdauer-Ausdehnungseinrichtung (19) angeschlossen ist und zur Erzeugung eines Aktivier-Signals (SE) vorgesehen ist.

4. Schaltung nach Anspruch 2 oder 3,
dadurch gekennzeichnet, daß die Zeitdauer- Ausdehnungseinrichtung (19) eine Verzögerungsschaltblock (19) mit einem Steuereingang (18) aufweist zur Erzeugung einer ersten Schaltflanke des ausgedehnten Signals (STP) bei der Erfassung einer vorbestimmten Schaltflanke an dem zweiten Steuereingang und zur Erzeugung einer zweiten Schaltflanke des ausgedehnten Signals mit einer Verzögerung in Bezug auf die zweite Schaltflanke an dem Steuereingang (18).

5. Schaltung nach Anspruch 4, dadurch gekennzeichnet, daß sie eine Ausdehnungs-Steuer-Einrichtung (9, 38) aufweist, die an den Steuereingang (18) des Verzögerungs-Schaltblocks (19) angeschlossen ist.

6. Schaltung nach Anspruch 5,
dadurch gekennzeichnet, daß die Ausdehnungs-Steuer-Einrichtung (9, 38) eine gesteuerte Schalteinrichtung (9) aufweist, die zwischen dem Ausgang (7) der Quellensignaleinrichtung (5) und dem Steuereingang (18) liegt und mindestens einen Steueranschluß besitzt, der an die Ausdehnungs-Deaktivierungs-Einrichtung (15) angeschlossen ist.

7. Schaltung nach Anspruch 6,
dadurch gekennzeichnet, daß die Schalteinrichtung (9) einen zweiten Steuer-Eingang besitzt, der an eine rekonfigurierbare Speichereinrichtung (11) angeschlossen ist, die einen ersten Eingang (R) besitzt, der mit einem reduzierten Betriebsmodus-Signal (SB) versorgt wird, und einen Ausgang (10), der ein Deaktivier-Signal (FF) abgibt, wobei die Speichereinrichtung (11) einen ersten Signal-Pegel des Deaktivier-Signals bei Empfang des reduzierten Betriebsmodus-Signals (SB) erzeugt.

8. Schaltung nach Anspruch 7,
dadurch gekennzeichnet, daß die rekonfigurierbare Speichereinrichtung (11) einen zweiten Eingang (S) besitzt, der an den Ausgang (20) des Verzögerungsschaltblocks (19) angeschlossen ist, wobei die Speichereinrichtung (11) einen zweiten Signal-Pegel des Deaktivier-Signal (FF) bei Erfassung der zweiten Schaltflanke des ausgedehnten Signals (STP) erzeugt.

9. Schaltung nach einem der vorangehenden Ansprüche 5 bis 8,
dadurch gekennzeichnet, daß die Ausdehnungs-Steuer-Einrichtung (9, 38) eine Aktivier-Einrichtung (38) für statischen Betrieb zur Abgabe eines Signals (SPP) mit einem vorbestimmten Logikpegel an den Steuereingang (18) aufweist.

10. Schaltung nach Anspruch 9,
dadurch gekennzeichnet, daß die Aktivier-Einrichtung (38) für statischen Betrieb an den Eingang der Einrichtung (37) zur Erzeugung eines niederpegligen Signals (LL), an eine Einrichtung (31) zur Erzeugung des reduzierten Betriebsmodus-Signals (SB) und an eine Einrichtung (40) zur Erzeugung eines Anforderungs-Signals für statischen Betrieb angeschlossen ist.

## Revendications

1. Procédé de production d'un signal de charge pour des mémoires non volatiles, comprenant l'étape consistant à produire un signal de charge (L) présentant une impulsion de validation de charge ; caractérisé en ce que ladite étape de production dudit signal de charge comprend l'étape de modulation de la durée de ladite impulsion de validation de charge, incluant les étapes consistant à produire une brève impulsion de charge (SP) ; produire une longue impulsion de charge (SCP) à partir de ladite brève impulsion de charge ; et à prélever de manière sélective ladite brève impulsion de charge ou ladite longue impulsion de charge.

2. Circuit (1) de production d'un signal de charge pour des mémoires non volatiles, comprenant un générateur (1) d'un signal de charge (L) possédant une impulsion de validation de charge ; caractérisé en ce que ledit générateur (1) comprend des moyens de modulation (5, 19, 21) pour moduler la durée de ladite impulsion de validation de charge, lesdits moyens de modulation comprenant des moyens formant source (5) pour produire au niveau de la sortie un bref signal de charge (SP) ayant une impulsion possédant une première durée ; des moyens d'extension de durée (19) alimentés au niveau de l'entrée par ledit bref signal de charge (SP) et produisant au niveau de la sortie un signal étendu (STP) avec une impulsion possédant une seconde durée supérieure à ladite première durée ; et des moyens de sélection (21) connectés auxdites sorties desdits moyens formant source et desdits moyens d'extension de durée, pour délivrer de façon sélective au niveau de la sortie (26) ledit bref signal de charge ou ledit signal étendu.

3. Circuit selon la revendication 2, caractérisé en ce qu'il comprend des moyens de validation/invalidation d'extension (15) connectés auxdits moyens d'extension de durée (19), pour produire un signal de validation (SE).

4. Circuit selon la revendication 2 ou 3, caractérisé en ce que lesdits moyens d'extension de durée (19) comprennent un bloc à retard (19) ayant une entrée de commande (18), pour produire un premier flanc de commutation dudit signal étendu (STP) lors de la détection d'un flanc de commutation prédéterminé au niveau de ladite entrée de commande, et pour produire un second flanc de commutation dudit signal étendu ayant un retard par rapport à un second flanc de commutation au niveau de ladite entrée de commande (18).

5. Circuit selon la revendication 4, caractérisé en ce qu'il comprend des moyens de commande d'extension (9, 38) connectés à ladite entrée de commande (18) dudit bloc à retard (19).

6. Circuit selon la revendication 5, caractérisé en ce que lesdits moyens de commande d'extension (9, 38) comprennent des moyens de commutation commandés (9) intercalés entre ladite sortie (7) desdits moyens formant source (5) et ladite entrée de commande (18) et possédant au moins une borne de commande connectée à des moyens d'invalidation d'extension (15).

7. Circuit selon la revendication 6, caractérisé en ce que lesdits moyens de commutation commandés (9) possèdent une seconde borne de commande connectée à des moyens de mémoire reconfigurables (11) possédant une première entrée (R) alimentée par un signal de mode de fonctionnement réduit (SB), et une sortie (10) délivrant un signal d'invalidation (FF) ; lesdits moyens de mémoire (11) produisant un premier niveau dudit signal d'invalidation lors de la réception dudit signal de mode de fonctionnement réduit (SB).

8. Circuit selon la revendication 7, caractérisé en ce que lesdits moyens de mémoire reconfigurables (11) possèdent une seconde entrée (S) connectée à la sortie (20) dudit bloc à retard (19) ; lesdits moyens de mémoire (11) produisant un second niveau dudit signal d'invalidation (FF) lors de la détection dudit second flanc de commutation dudit signal étendu (STP).

9. Circuit selon l'une quelconque des revendications 5 à 8, caractérisé en ce que lesdits moyens de commande d'extension (9, 38) comprennent des moyens (38) de validation d'un fonctionnement statique pour délivrer un signal (SPP) ayant un niveau logique prédéterminé au niveau de ladite entrée de commande (18).

10. Circuit selon la revendication 9, caractérisé en ce que lesdits moyens (38) de validation d'un fonctionnement statique sont connectés, au niveau de l'entrée, à des moyens (37) destinés à produire un signal de niveau bas (L), à des moyens (31) destinés à produire ledit signal de mode de fonctionnement réduit (SB), et à des moyens (40) destinés à produire un signal de demande de fonctionnement statique.
